(19) Europäisches Patentamt
European Patent Office
Office européen des brevets

(11) **EP 2 329 685 B1**

(12) **EUROPÄISCHE PATENTSCHRIFT**

(45) Veröffentlichungstag und Bekanntmachung des Hinweises auf die Patenterteilung:
**10.06.2015 Patentblatt 2015/24**

(21) Anmeldenummer: **09778736.0**

(22) Anmeldetag: **25.09.2009**

(51) Int Cl.:
*H05B 33/08* (2006.01)    *G01R 31/26* (2014.01)

(86) Internationale Anmeldenummer:
**PCT/EP2009/006951**

(87) Internationale Veröffentlichungsnummer:
**WO 2010/034509 (01.04.2010 Gazette 2010/13)**

(54) **GERÄT UND VERFAHREN ZUM BETRIEB VON LEUCHTMITTELN**

DEVICE AND METHOD FOR THE OPERATION OF ILLUMINANTS

DISPOSITIF ET PROCÉDÉ DE FONCTIONNEMENT DES MOYENS LUMINEUX

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **25.09.2008 DE 102008048899**

(43) Veröffentlichungstag der Anmeldung:
**08.06.2011 Patentblatt 2011/23**

(73) Patentinhaber: **Tridonic GmbH & Co KG**
**6851 Dornbirn (AT)**

(72) Erfinder:
• **ZUDRELL-KOCH, Stefan**
**A-6845 Hohenems (AT)**
• **KNOEDGEN, Horst**
**80997 München (DE)**

(74) Vertreter: **Rupp, Christian et al**
**Mitscherlich PartmbB**
**Patent- und Rechtsanwälte**
**Sonnenstraße 33**
**80331 München (DE)**

(56) Entgegenhaltungen:
EP-A1- 1 379 108    EP-A1- 1 973 385
WO-A2-2008/120143    DE-U1-202007 015 857
US-A1- 2003 071 821    US-A1- 2006 274 540

• **CHEUNG W N ET AL: "MODELLING OF A DH LED USING ONE-PORT IMPEDANCE MEASUREMENTS" INTERNATIONAL JOURNAL OF OPTOELECTRONICS (INCL.OPTICAL COMPUTING& PROCESSING), TAYLOR & FRANCIS, LONDON, GB, Bd. 12, Nr. 3, 1. Juli 1998 (1998-07-01), Seiten 91-97, XP000801752 ISSN: 0952-5432**

EP 2 329 685 B1

**Beschreibung**

Die vorliegende Erfindung bezieht sich auf das Gebiet der Geräte und Verfahren zum Betrieb von Leuchtmitteln, insbesondere OLEDs.

Eine organische Leuchtdiode, kurz OLED (Kurzform für engl.: "Organic Light Emitting Diode"), ist ein dünnfilmiges, leuchtendes Bauelement aus organischen, halbleitenden Materialien, das sich von den anorganischen Leuchtdioden (LED) dadurch unterscheidet, dass Stromdichte und Leuchtdichte geringer sind und keine einkristallinen Materialien erforderlich sind. Da OLEDs auf fast jedes Material gedruckt werden können, bieten sie gegenüber der LCD-Technologie eine signifikante Kostenersparnis. Für OLEDs können auch biegsame Trägermaterialien (flexible Substrate, Folien) verwendet werden, wodurch völlig neue Möglichkeiten eröffnet werden. Zum Betreiben von OLEDs müssen Treiberschaltungen verwendet werden. Zur Dimensionierung der Treiberschaltungen müssen die elektrischen Eigenschaften der einzelnen OLEDs, aber auch die von OLED-Kombinationen bekannt sein. Die Hersteller liefern dazu in der Regel Datenblätter mit den betreffenden Strom-/Spannungs-Kennlinien der OLEDs.

Es ist bereits bekannt, als Ersatzschaltbild für eine OLED eine Parallelschaltung einer Ersatzkapazität und einer Ersatzdiode sowie einem mit dieser Parallelschaltung in Serie geschalteten Ersatzwiderstand anzunehmen.

In der EP 1 973 385 A1 wird ein Verfahren zur Bestimmung der Kapazität einer OLED offenbart.

Der Erfindung liegt die Aufgabe zugrunde, Möglichkeiten anzugeben, die Elemente des Ersatzschaltbildes ermitteln zu können.

Zur Lösung dieser Aufgabe wird gemäß Anspruch 1 vorgeschlagen, dass die Bestimmung der Werte für den Ersatzwiderstand $R_E$ und die Ersatzkapazität $C_E$ zeitlich getrennt von der Bestimmung der Werte für die Ersatzdiode $D_E$ erfolgen soll.

Der relativ hohe Ersatzwiderstand liegt in der Größenordnung von 15 $\Omega$ und ist dadurch bedingt, dass die planaren Leiterbahnen sehr dünn sind. Die Ersatzkapazität ist wegen der planaren Ausdehnung der OLED ebenfalls relativ hoch und erreicht Werte zwischen 200 und 400 pF/mm$^2$. Die Kennlinie der Ersatzdiode ist die einer üblichen Diode, d. h. sie wird erst oberhalb von 2,5 bis 3 V leitend.

Einer Ausgestaltung des erfindungsgemäßen Verfahrens besteht darin, dass die OLEDs zur Bestimmung des Ersatzwiderstandes $R_E$ mit einem bekannten Messstrom $I_M$, vorzugsweise einem Messstrom-Impuls, beaufschlagt wird, dass unmittelbar nach Beginn des Messstromes $I_M$ der Spannungsabfall $U_1$ über der OLED gemessen wird, und zwar noch bevor sich an der Ersatzkapazität $C_E$ eine nennenswerte Ladespannung aufbauen kann, und dass der Ersatzwiderstand $R_E$ dann nach der Formel

$$R_E = U_1 \; / \; I_M$$

$$(1)$$

berechnet wird.

Eine zweite Weiterbildung des erfindungsgemäßen Verfahrens besteht darin, dass die OLED zur Bestimmung der Ersatzkapazität $C_E$ über eine bekannte Ladeperiode $\Delta t$ mit einem eingeprägten Ladestrom $I_M$ beaufschlagt wird, dass der Spannungsabfall $U_1$ über der OLED zu Beginn und der Spannungsabfall $U_2$ am Ende der Ladeperiode gemessen werden, und dass die Ersatzkapazität $C_E$ nach der Formel

$$C_E = I_M \cdot \Delta t \; / \; (U_2 - U_{1)}$$

$$(2)$$

berechnet wird, wobei - wenn der Ladestrom in Durchlassrichtung der Ersatzdiode $D_E$ fließt - die Ladeperiode $\Delta t$ so kurz bemessen werden muss, dass der Spannungsabfall $U_2$ am Ende der Ladeperiode nach unterhalb der Spannung liegt, bei der die Ersatzdiode $D_E$ leitend wird.

Die Bestimmung der Ersatzkapazität $C_E$ kann alternativ zu dem zuletzt beschriebenen Verfahrensschritt auch dadurch erfolgen, dass die OLED mit einer zuvor auf eine bekannte Referenzspannung $U_R$ aufgeladene bekannte Referenzkapazität $C_R$ verbunden wird, dass dann die durch die Ladungsausgleich verminderte Ausgleichsspannung $U_A$ an der Referenzkapazität $C_R$ oder die mit dieser dann identische Spannung an der OLED gemessen wird, und dass die Ersatzkapazität $C_E$ dann nach der Formel

$$C_E = C_R \cdot U_R / U_A - 1$$

(3)

berechnet wird, wobei - wenn die Referenzspannung $U_R$ in Durchlassrichtung der Ersatzdiode $R_E$ gerichtet ist - die Referenzspannung $U_R$ so bemessen sein muss, dass die sich nach dem Ladungsausgleich ergebende verminderte Ausgleichsspannung $U_A$ kleiner als die Spannung ist, bei der die Ersatzdiode $D_E$ leitende birgt.

Gemäß einer dritten Ausgestaltung des erfindungsgemäßen Verfahrens kann die Bestimmung der Ersatzdiode $D_E$ in üblicher Weise durch Ausmessen der Strom-/Spannungs-Kennlinie der OLED bestimmt werden.

Um für die Messungen in jedem Fall definierte Verhältnisse zu haben, wird ferner vorgeschlagen, dass die OLEDs vor Beginn der Messungen mit einer Startspannung $U_S$ beaufschlagt wird, die vorzugsweise 0 ist.

Wenn mehre OLEDs durch Parallel- und/oder Serienschaltung zu OLED-Kombinationen zusammengeschaltet werden, so kann die Konfiguration der OLED-Kombinationen dadurch herausgefunden werden, dass der Knickpunkt der Strom-/Spannungs-Kennlinie der OLED-Kombination als Unterscheidungskriterium herangezogen und ausgewertet wird. Unter "Knickpunkt" soll der Punkt verstanden werden, bei dem die Diode leitend wird.

Die Erfindung betrifft schließlich noch eine Messeinrichtung zum Bestimmen der elektrischen Eigenschaften einer OLED, mit der das erfindungsgemäße Verfahren durchgeführt werden kann. Die Messeinrichtung ist gekennzeichnet durch Mittel zur Erzeugung eines Mess- und/oder Ladestromes und durch Mittel zum Messen des Spannungsabfalls über der OLED und/oder der Spannung über der Referenzkapazität $C_R$.

Eine Weiterbildung für die Messeinrichtung kann darin bestehen, dass diese mit einer Startspannungsquelle versehen ist.

Die Erfindung betrifft auch ein Betriebsgerät zum Betreiben einer OLED, welches eine Messeinrichtung zum Bestimmen der elektrischen Eigenschaften einer OLED, mit der das erfindungsgemäße Verfahren durchgeführt werden kann, enthält. Vorzugsweise enthält das Betriebsgerät eine Treiberschaltung, in die die Messeinrichtung zum Bestimmen der elektrischen Eigenschaften einer OLED, mit der das erfindungsgemäße Verfahren durchgeführt werden kann, integriert ist. Das Betriebsgerät, vorzugsweise die Treiberschaltung, kann die Startspannungsquelle und/oder Mittel zur Erzeugung eines Mess- und/oder Ladestromes und/oder Mittel zum Messen des Spannungsabfalls über der OLED und/oder der Spannung über der Referenzkapazität $C_R$ aufweisen.

Das Betriebsgerät kann Teil einer Beleuchtungseinheit sein, welche zum Betreiben von OLED geeignet ist, wobei diese Beleuchtungseinheit eine Messeinrichtung zum Bestimmen der elektrischen Eigenschaften einer OLED aufweist, mit der das erfindungsgemäße Verfahren durchgeführt werden kann.

Die Erfindung betrifft auch ein Verfahren zum Bestimmen des Typs einer durch ein Betriebsgerät zu betreibenden OLED mit folgenden Schritten:

- Durchführung einer Messung eines Kennwertes an der OLED, und
- Bestimmung des OLED-Typs bzw. der OLED-Größe aufgrund der durchgeführten Messung.

Für dieses Verfahren kann die Bestimmung des OLED-Typs bzw. der OLED-Größe aufgrund der durchgeführten Messung durch Vergleich der durchgeführten Messung mit entsprechenden Vorgabewerten, die in einer Tabelle abgelegt sind, erfolgen.

Die Kennwerte der OLED, welche für die Bestimmung des OLED-Typs bzw. der OLED-Größe genutzt werden können, können insbesondere die Werte für den Ersatzwiderstand $R_E$, die Ersatzkapazität $C_E$ und / oder die Ersatzdiode $D_E$ sein. Die Bestimmung der Werte für den Ersatzwiderstand $R_E$ und die Ersatzkapazität $C_E$ kann zeitlich getrennt von der Bestimmung der Werte für die Ersatzdiode $D_E$ erfolgen. Anhand der bestimmten Kennwerte für die OLED können die erforderlichen Betriebsparameter für das Betriebsgerät eingestellt werden, um die angeschlossene OLED anhand der erfolgten Bestimmung des OLED-Typs bzw. der OLED-Größe korrekt zu betreiben.

Ausführungsbeispiele der Erfindung werden nachfolgend anhand der Zeichnungen beschrieben.

Es zeigen:

Fig. 1    das Ersatzschaltbild für eine OLED;

Fig. 2    eine erste Messanordnung zur Bestimmung der Ersatzbauelemente der Ersatzschaltung;

Fig. 3    den mit der Messeinrichtung zu bestimmenden Verlauf des Spannungsabfalls über der OLED in Fig. 2 in Abhängigkeit von der Zeit;

Fig. 4    eine alternative Messanordnung zu Fig. 2, die insbesondere zum Bestimmen der Ersatzkapazität geeignet ist.

Fig. 5    eine Kombination von vier OLEDs, von denen jeweils zwei in Serie und die beiden Serienschaltungen parallel geschaltet sind.

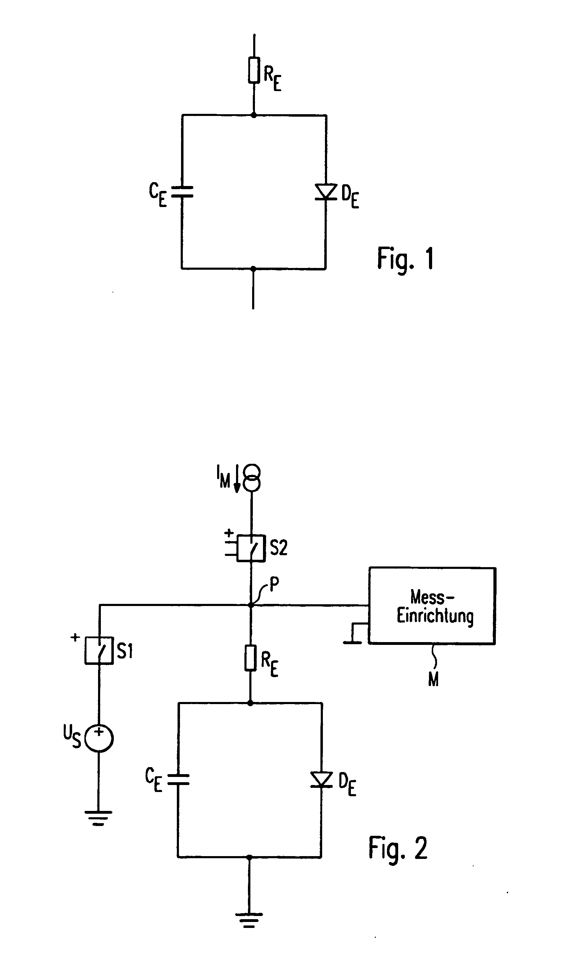

Das in Fig. 1 gezeigte Ersatzschaltbild für eine OLED besteht aus einer Parallelschaltung einer Ersatzkapazität $C_E$ und einer Ersatzdiode $D_E$, wobei die Parallelschaltung mit einem Ersatzwiderstand $R_E$ in Serie geschaltet ist.

In Fig. 2 ist eine auszumessende OLED wiederum durch das Ersatzschaltbild gemäß Fig. 1 repräsentiert. Die OLED ist mit einem Anschluss an Masse gelegt und mit ihrem anderen Anschluss P mit einer Messeinrichtung M verbunden. Der Anschluss P ist demnach der Messpunkt. Mit dem Messpunkt P ist auch eine Stromquelle $I_M$ für einen eingeprägten Messstrom über einen Schalter S2 verbunden. Ferner ist mit dem Messpunkt P eine Startspannungsquelle $U_S$ über einen Schalter S1 verbunden. Die Startspannungsquelle $U_S$ hat eine Spannung von 0 V, um die OLED auf ein definiertes Potential zu legen.

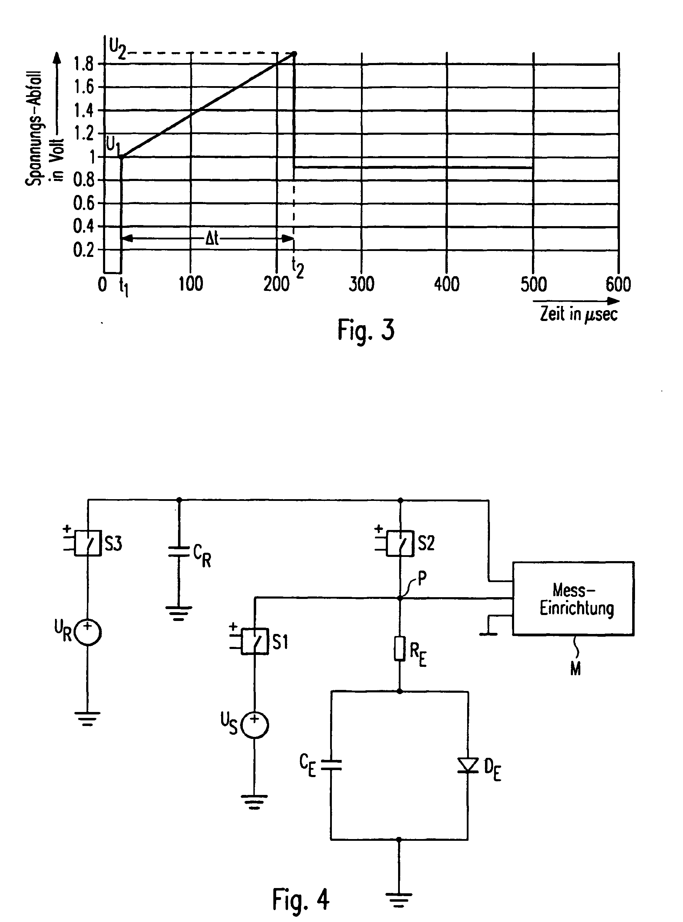

Der zeitliche Verlauf der von der Messeinrichtung M gemessenen Spannung ist in Fig. 3 dargestellt.

Zum Zeitpunkt 0 wird der Schalter S1 geschlossen, so dass die OLED auf die definierte Spannung von 0 V gelegt wird und auch die Ersatzkapazität $C_E$ keine Ladung hat.

Zum Zeitpunkt $t_1$ wird der Schalter S1 geöffnet, und der Schalter S2 wird geschlossen. Dadurch fließt der eingeprägte Messstrom $I_M$ in die OLED. Für die Spannung am Messpunkt P ist zunächst nur der Spannungsabfall über dem Ersatzwiderstand $R_E$ entscheidend, da die Ersatzkapazität $C_E$ zunächst noch spannungslos ist und sich erst mit der Zeit auflädt. Der Spannungsabfall $U_1$ am Messpunkt P beträgt in dem dargestellten Beispiel zum Zeitpunkt $t_1$ (siehe Fig. 3) 1 V. Bei dieser Spannung ist die Ersatzdiode $D_E$ noch im nichtleitenden Bereich, so dass sich der Ersatzwiderstand $R_E$ zum Zeitpunkt $t_1$ in einfacher Weise durch die Formel

$$R_E = U_1 / I_M$$

$$(4)$$

errechnen lässt. $I_M$ und $U_1$ sind bekannt.

Von dem Zeitpunkt $t_1$ bis zum Zeitpunkt $t_2$ steigt nun die Spannung am Messpunkt P linear bis auf die Spannung $U_2$ an, die im vorliegenden Beispiel 1,9 V beträgt. Auch bei dieser Spannung befindet sich die Ersatzdiode $D_E$ noch im nichtleitenden Bereich. Der lineare Anstieg der Spannung ist durch das Aufladen der Ersatzkapazität $C_E$ und die Tatsache bedingt, dass es sich bei $I_M$ um einen eingeprägten Strom handelt.

Zum Zeitpunkt $t_2$ wird der Schalter S2 wieder geöffnet, mit der Folge, dass die Aufladung der Ersatzkapazität $C_E$ unterbrochen und kein Ladestrom mehr durch den Ersatzwiderstand $R_E$ fließt. Die Spannung am Messpunkt P sinkt dementsprechend wieder ab.

Während des Messvorganges registriert die Messeinrichtung M die Spannungsabfälle $U_1$ und $U_2$ am Messpunkt P und die Ladeperiode $\Delta t$ als Differenz der Zeitpunkte $t_2$ und $t_1$. Ferner ist der eingeprägte Messstrom $I_M$ bekannt.

Durch den eingeprägten Messstrom $I_M$ werden Ladungen Q auf die Ersatzkapazität $C_E$ befördert. Zum Zeitpunkt $t_1$ gilt für die Spannung an der Ersatzkapazität $C_E$

$$U_{C1} = Q_1 / C_E$$

$$(5)$$

Zum Zeitpunkt $t_2$ gilt für die Spannung an der Ersatzkapazität $C_E$

$$U_{C2} = Q_2 / C_E$$

$$(6)$$

Weiterhin gilt

$$I_M = \Delta Q / \Delta t$$

$$(7)$$

und

$$\Delta Q = Q_2 - Q_1 = C_E \cdot (U_{C2} - U_{C1})$$

$$(8)$$

Für die Spannung an der Ersatzkapazität $C_E$ gilt zu den Zeitpunkten $t_1$ und $t_2$ ferner

$$U_{C2} = U_2 - I_M \cdot R_E$$

$$(9)$$

und

$$U_{C1} = U_1 - I_M \cdot R_E$$

$$(10)$$

Subtrahiert man (10) von (9), so erhält man

$$U_{C2} - U_{C1} = U_2 - U_1$$

$$(11)$$

Vereinigt man die Formeln (9) und (11), so erhält man

$$\Delta Q = C_E \cdot (U_2 - U_1)$$

$$(12)$$

Durch Kombination der Formeln (7) und (12) erhält man

$$I_M \cdot \Delta t = C_E \cdot (U_2 - U_1)$$

Damit kommt man zu der Formel, mit der man die Ersatzkapazität berechnen kann, nämlich

$$C_E = I_M \cdot \Delta t / (U_2 - U_1)$$

$$(14) = (2)$$

Im zuvor beschriebenen Beispiel hat der eingeprägte Messstrom $I_M$ eine in Durchlassrichtung der Ersatzdiode $D_E$ verlaufende Flussrichtung. Daher muss darauf geachtet werden, dass die höchste an der Ersatzdiode $D_E$ liegende Ladespannung der Ersatzkapazität $C_E$ unterhalb der Spannung liegt, bei der die Ladediode $D_E$ leitend wird. Das ist auf jeden Fall dann gegeben, wenn - wie in Fig. 3 gezeigt ist - die Spannung $U_2$ am Messpunkt P zum Zeitpunkt $t_2$ 1,9 V ist. Die Spannung an der Ersatzdiode $D_E$ ist dann um den Spannungsabfall an dem Ersatzwiderstand $D_E$ vermindert und somit im sicheren Bereich. Die vorstehend gemachten Überlegungen gelten selbstverständlich auch für die Startspannung $U_S$.
Fig. 4 zeigt eine Messanordnung, mit welcher die Ersatzkapazität $C_E$ anders als mit der in Fig. 2 gezeigten Messanordnung gemessen werden kann.

Anstelle einer Stromquelle ist in Fig. 4 ein Referenzkondensator $C_R$ vorgesehen, der mittels einer Spannungsquelle über einen Schalter S3 auf eine Referenzspannung $U_R$ aufgeladen werden kann.

Nach dem Aufladen der Referenzkapazität $C_R$ wird der Schalter S3 geöffnet, und der Schalter S2 wird geschlossen. Dadurch kommt es zu einem Ladungsausgleich zwischen der Referenzkapazität $C_R$ und der Ersatzkapazität $C_E$ der OLED. Mit der Messeinrichtung M wird zunächst die Ladespannung $U_R$ an der Referenzkapazität $C_R$ gemessen. Nach dem Ladungsausgleich wird der Schalter S2 wieder geöffnet und mit der Messeinrichtung M wird der Spannungsabfall am Messpunkt P oder die nunmehr reduzierte Ausgleichsspannung $U_A$ an der Referenzkapazität $C_R$ gemessen (der Schalter S3 ist dabei geöffnet). Durch den Ladungsausgleich müssen auch nach dem Öffnen des Schalters S2 die Spannungen an der Referenzkapazität $C_R$ einerseits und am Messpunkt P andererseits gleich sein, nämlich gleich der Ausgleichsspannung $U_A$.

Zunächst gilt für den auf die Referenzspannung $U_R$ aufgeladenen Referenzkondensator $C_R$

$$U_R = Q_R \;/\; C_R \tag{15}$$

Nach dem Ladungsausgleich stellt sich die Ausgleichsspannung $U_A$ ein, die sich durch die folgende Formel ergibt

$$U_A = Q_R \;/\; (C_R + C_E) \tag{16}$$

Durch Kombination der Formeln (15) und (16) ergibt sich die Formel, mit der man ebenfalls die Ersatzkapazität $C_E$ errechnen kann, nämlich

$$C_E = C_R \cdot U_R \;/\; U_A \; - 1 \tag{17}=(3)$$

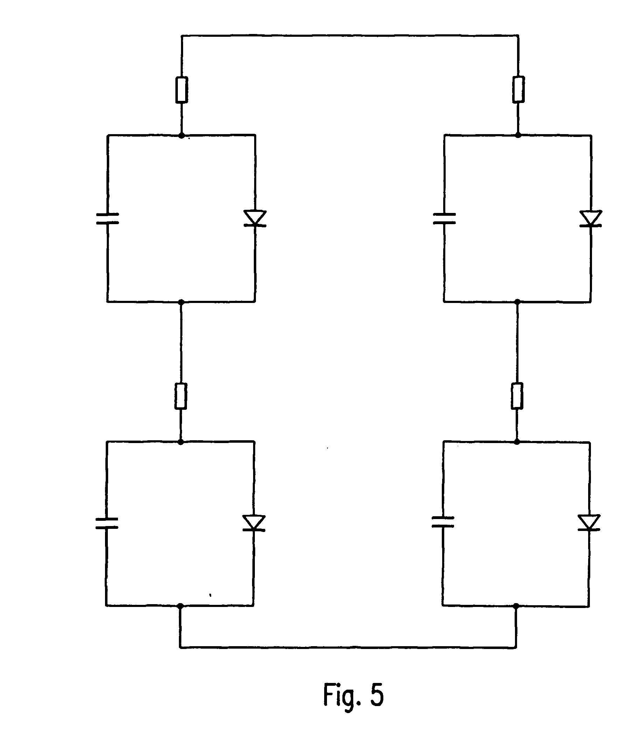

Die Ersatzdiode $D_E$ wird in üblicher Weise durch Ausmessen der Strom-/Spannungs-Kennlinie der OLED bestimmt. Diese Kennlinie ist nichtlinear. Diese Eigenschaft erlaubt es, die Strom-/Spannungs-Kennlinie heranzuziehen und auszuwerten, um die einzelnen OLED-Kombinationen voneinander unterscheiden zu können. Eine mögliche OLED-Kombination ist in Fig. 5 gezeigt. Diese besteht aus vier OLEDs, von denen jeweils zwei in Serie geschaltet sind und zwei dieser Serienschaltungen zu einer Parallelschaltung zusammengefasst sind. Es sind auch andere OLED-Kombinationen möglich. Diese unterscheiden sich dann durch eine andere Lage des Knickpunktes in der Strom-/Spannungs-Kennlinie, die somit zur Differenzierung herangezogen werden kann.

Die Messeinrichtung M zum Bestimmen der elektrischen Eigenschaften einer OLED, mit der das erfindungsgemäße Verfahren durchgeführt werden kann, kann in einem Betriebsgerät zum Betreiben einer OLED enthalten sein. Vorzugsweise enthält das Betriebsgerät eine Treiberschaltung, welche nach der Durchführung der Bestimmung der elektrischen Eigenschaften einer OLED die angeschlossene OLED entsprechend der bestimmten Eigenschaften betreiben kann.

Die Treiberschaltung des Betriebsgerätes kann eine integrierte Steuerschaltung aufweisen, welche die Treiberschaltung steuern oder auch regeln kann. Die integrierte Steuerschaltung kann beispielsweise ein Mikrocontroller oder ein ASIC sein.

Das Betriebsgerät kann über zumindest eine Schnittstelle verfügen. Die Schnittstelle kann mit der integrierten Steuerschaltung verbunden sein. Über die Schnittstelle können dem Betriebsgerät Steuerbefehle für den entsprechenden Betrieb der OLED übermittelt werden, wie beispielsweise Ein- und Ausschaltbefehle, Helligkeitsänderungen, Vorgaben über die einzustellende Farbe oder auch Statusinformationen, die einen speziellen Betriebsmodus initiieren können. Das Betriebsgerät kann über die Schnittstelle Informationen über die Ergebnisse der Bestimmung der elektrischen Eigenschaften einer OLED übermitteln. Aufgrund der übermittelten Informationen können Steuergeräte ihre Steuerbefehle entsprechend diesen Informationen anpassen. So kann beispielsweise aufgrund der Bestimmung des OLED-Typs oder der OLED-Größe die erforderlichen Helligkeitsbefehle und/oder Farbbefehle angepasst werden, um die verfügbaren Helligkeiten und/oder Farben der angeschlossenen OLED den Benutzeranforderungen anzupassen.

Das Betriebsgerät kann als Treiberschaltung einen Schaltregler, beispielsweise einen AC-DC-Wandler oder DC-DC-Wandler, enthalten. Das Betriebsgerät kann einen PFC (aktive oder passive Leistungsfaktorkorrekturschaltung) enthalten. Der PFC kann beispielsweise durch einen Boost-Konverter, Buck-Boost-Konverter, einen Flyback-Konverter oder auch durch eine "Valley Fill Schaltung" (Pumpschaltung) gebildet werden.

Das Betriebsgerät kann eine Potentialtrennung aufweisen. Diese Potentialtrennung kann beispielsweise über einen Transformator erfolgen.

Das Betriebsgerät kann beispielsweise einen Flyback-Konverter, einen Forward-Konverter oder eine Halbbrücken-Konverter mit Transformator enthalten.

Wenn das Betriebsgerät einen PFC aufweist, kann es als sogenannte einstufige Topologie, beispielsweise durch einen Flyback-Konverter, der in der sogenannten Borderline-Betriebsart (Betrieb im Grenzbereich zwischen kontinuierlichem und diskontinuierlichem Strom) arbeitet und somit sowohl die PFC-Funktion als auch den OLED-Betrieb übernimmt, oder auch durch eine sogenannte zweistufige Topologie, beispielsweise durch einen Boost-Konverter als PFC mit einem nachfolgendem Halbbrücken-Konverter oder Vollbrücken-Konverter zum OLED-Betrieb, ausgeführt sein.

Das Betriebsgerät kann Mittel zur Regelung des Stromes durch die OLED, zur Regelung der Spannung über die OLED oder auch zur Regelung der der OLED zugeführten Leistung aufweisen. Bei der zu betreibenden OLED kann es sich beispielsweise auch um eine OLED-Kombination wie in Fig. 5 dargestellt handeln.

Das Betriebsgerät kann einen Speicher aufweisen, in dem die elektrischen Eigenschaften der OLED, die durch das erfindungsgemäße Verfahren bestimmt wurden, abgelegt werden. Zusätzlich oder alternativ können die für den Betrieb der OLED erforderlichen Betriebsparameter für das Betriebsgerät eingestellt werden, um die angeschlossene OLED anhand der erfolgten Bestimmung des OLED-Typs bzw. der OLED-Größe korrekt zu betreiben. Auch der OLED-Typ bzw. die OLED-Größe, welche aufgrund der Messung bestimmt wurde, kann in dem Speicher abgelegt werden. Beispielsweise kann die Bestimmung des OLED-Typs bzw. der OLED-Größe durch Vergleich der durchgeführten Messung mit entsprechenden Vorgabewerten, die in einer Tabelle, beispielsweise in dem Speicher, abgelegt sind, erfolgen. Der Speicher kann in der integrierten Steuerschaltung enthalten sein oder als eigene integrierte Schaltung mit der integrierten Steuerschaltung verbunden sein. Der Speicher kann beispielsweise ein Flash-Speicher sein.

Die Messeinrichtung M zum Bestimmen der elektrischen Eigenschaften einer OLED, mit der das erfindungsgemäße Verfahren durchgeführt werden kann, kann vorzugsweise in die Treiberschaltung, welche Bestandteil des Betriebsgerätes ist, integriert sein. Das Betriebsgerät, vorzugsweise die Treiberschaltung, kann die Startspannungsquelle $U_s$ und/oder Mittel zur Erzeugung eines Mess- und/oder Ladestromes und/oder Mittel zum Messen des Spannungsabfalls über der OLED und/oder der Spannung über der Referenzkapazität $C_R$ aufweisen. Die Treiberschaltung kann auch einen Schalter S1, einen Schalter S2 und/oder eine Spannungsquelle zur Erzeugung einer Referenzspannung $U_R$ sowie einen Schalter S3 enthalten. Durch Anwendung des erfindungsgemäßen Verfahrens kann das Betriebsgerät beispielsweise für eine OLED-Kombination wie in Fig. 5 gezeigt die elektrischen Eigenschaften bestimmen und somit auch den OLED-Typ bzw. die OLED-Größe einer solchen OLED-Kombination ermitteln und daraufhin korrekt betreiben.

Das Betriebsgerät kann Teil einer Beleuchtungseinheit sein, welche zum Betreiben von OLED geeignet ist, wobei diese Beleuchtungseinheit eine Messeinrichtung zum Bestimmen der elektrischen Eigenschaften einer OLED aufweist, mit der das erfindungsgemäße Verfahren durchgeführt werden kann.

Somit wird ein Verfahren zum Bestimmen des Typs einer durch ein Betriebsgerät zu betreibenden OLED mit folgenden Schritten ermöglicht:

- Durchführung einer Messung eines Kennwertes an der OLED, und
- Bestimmung des OLED-Typs bzw. der OLED-Größe aufgrund der durchgeführten Messung.

Für dieses Verfahren kann die Bestimmung des OLED-Typs bzw. der OLED-Größe aufgrund der durchgeführten Messung durch Vergleich der durchgeführten Messung mit entsprechenden Vorgabewerten, die in einer Tabelle abgelegt sind, erfolgen.

Die Kennwerte der OLED, welche für die Bestimmung des OLED-Typs bzw. der OLED-Größe genutzt werden können, können insbesondere die Werte für den Ersatzwiderstand $R_E$, die Ersatzkapazität $C_E$ und / oder die Ersatzdiode $D_E$ sein. Die Bestimmung der Werte für den Ersatzwiderstand $R_E$ und die Ersatzkapazität $C_E$ kann zeitlich getrennt von der Bestimmung der Werte für die Ersatzdiode $D_E$ erfolgen. Anhand der bestimmten Kennwerte für die OLED können die erforderlichen Betriebsparameter für das Betriebsgerät eingestellt werden, um die angeschlossene OLED anhand der erfolgten Bestimmung des OLED-Typs bzw. der OLED-Größe korrekt zu betreiben. Die Bestimmung der Werte für den Ersatzwiderstand $R_E$ und die Ersatzkapazität $C_E$ kann zeitlich getrennt von der Bestimmung der Werte für die Ersatzdiode $D_E$ kann anhand der zu den Fig. 2 und/oder Fig. 4 beschriebenen Messanordnungen erfolgen.

**Patentansprüche**

1. Verfahren zum Bestimmen der elektrischen Eigenschaften einer OLED, deren Ersatzschaltbild aus einer Parallelschaltung einer Ersatzdiode ($D_E$) und einer Ersatzkapazität ($C_E$) und einem mit dieser Parallelschaltung in Serie geschalteten Ersatzwiderstand ($R_E$) besteht,
   **dadurch gekennzeichnet,**
   **dass** die Bestimmung der Werte für den Ersatzwiderstand ($R_E$) und die Ersatzkapazität ($C_E$) zeitlich getrennt von der Bestimmung der Werte für die Ersatzdiode ($D_E$) mittels Ausmessens der Strom-/ Spannungskennline der OLED erfolgt, und
   die OLED zur Bestimmung des Ersatzwiderstandes ($R_E$) mit einem bekannten Messstrom ($I_M$), vorzugsweise einem Messstrom-Impuls, beaufschlagt wird.

2. Verfahren nach Anspruch 1,
   **dadurch gekennzeichnet,**
   **dass** unmittelbar nach Beginn des Messstromes (IM) der Spannungsabfall($U_1$) über der OLED gemessen wird, und zwar noch bevor sich an der Ersatzkapazität ($C_E$) eine nennenswerte Ladespannung aufbauen kann, und
   **dass** der Ersatzwiderstand ($R_E$) dann nach der Formel

$$R_E = U_1 / I_M \qquad\qquad (1)$$

   berechnet wird.

3. Verfahren nach Anspruch 1 oder 2,
   **dadurch gekennzeichnet,**
   **dass** die OLED zur Bestimmung der Ersatzkapazität ($C_E$) über eine bekannte Ladeperiode ($\Delta t$) mit einem eingeprägten Ladestrom ($I_M$) beaufschlagt wird, dass der Spannungsabfall ($U_1$) über der OLED zu Beginn und der Spannungsabfall ($U_2$) am Ende der Ladeperiode gemessen werden, und
   **dass** die Ersatzkapazität ($C_E$) nach der Formel

$$C_E = IM \cdot \Delta t / (U_2 - U_1) \qquad\qquad (2)$$

   errechnet wird,
   wobei - wenn der Ladestrom in Durchlassrichtung der Ersatzdiode ($D_E$) fließt - die Ladeperiode ($\Delta t$) so kurz bemessen werden muss, dass der Spannungsabfall ($U_2$) am Ende der Ladeperiode noch unterhalb der Spannung liegt, bei der die Ersatzdiode ($D_E$) leitend wird.

4. Verfahren nach Anspruch 1 oder 2,
   **dadurch gekennzeichnet,**
   **dass** die OLED zur Bestimmung der Ersatzkapazität ($C_E$) mit einer zuvor auf eine bekannte Referenzspannung ($U_R$) aufgeladene bekannte Referenzkapazität ($C_R$) verbunden wird, dass dann die durch den Ladungsausgleich verminderte Ausgleichsspannung ($U_A$) an der Referenzkapazität ($C_R$) oder die mit dieser dann identische Spannung an der OLED gemessen wird, und
   **dass** die Ersatzkapazität ($C_E$) dann nach der Formel

$$C_E = C_R \cdot U_R/U_A - 1 \qquad\qquad (3)$$

   berechnet wird,
   wobei - wenn die Referenzspannung ($U_R$) in Durchlassrichtung der Ersatzdiode ($D_E$) gerichtet ist - die Referenzspannung ($U_R$) so bemessen sein muss, dass sich die nach dem Ladungsausgleich ergebende verminderte Ausgleichsspannung ($U_A$) kleiner als die Spannung ist, bei der die Ersatzdiode ($D_E$) leitend wird.

5. Verfahren nach einem der vorstehenden Ansprüche,
**dadurch gekennzeichnet,**
**dass** zur Bestimmung der Ersatzdiode ($D_E$) die Strom-/Spannungs-Kennlinie der OLED ausgemessen wird.

6. Verfahren nach einem der vorstehenden Ansprüche,
**dadurch gekennzeichnet,**
**dass** die OLED vor Beginn der Messungen mit einer Startspannung ($U_S$) beaufschlagt wird, die vorzugsweise Null ist.

7. Verfahren zum Bestimmen der Konfiguration einer aus mehreren OLEDs bestehenden OLED-Kombination,
**dadurch gekennzeichnet,**
**dass** der Knickpunkt der Strom-/Spannungs-Kennlinie der OLED-Kombination als Unterscheidungskriterium herangezogen und ausgewertet wird.

8. Messeinrichtung zum Bestimmen der elektrischen Eigenschaften einer OLED, zur Durchführung des Verfahrens nach einem der Ansprüche 1 bis 7,
**gekennzeichnet durch**
Mittel zur Erzeugung eines Mess- und/oder Ladestromes und Mittel (M) zum Messen des Spannungsabfalls über der OLED und/oder Spannung über der Referenzkapazität ($C_R$).

9. Messeinrichtung nach Anspruch 8, ferner
**gekennzeichnet durch**
eine Startspannungsquelle ($U_S$).

10. Betriebsgerät für eine OLED, aufweisend eine Messeinrichtung zum Bestimmen der elektrischen Eigenschaften einer OLED, zur Durchführung des Verfahrens nach einem der Ansprüche 1 bis 7.

11. Betriebsgerät nach Anspruch 10,
**gekennzeichnet durch**
eine Startspannungsquelle ($U_S$).

**Claims**

1. Method for determining the electrical properties of an OLED, the equivalent circuit of which consists of a parallel circuit of a replacement diode ($D_E$) and of a replacement capacity ($C_E$) and of a replacement resistance ($R_E$) serially connected with this parallel circuit, **characterised in that** the values for the replacement resistance ($R_E$) and the replacement capacity ($C_E$) are determined separated in time from the determination of the values for the replacement diode ($D_E$) by means of measurement of the current-voltage characteristic of the OLED, and the OLED for determining the replacement resistance ($R_E$) is subjected to a known measuring current ($I_M$), preferably a measuring current pulse.

2. Method according to claim 1, **characterised in that** immediately after the start of the measuring current ($I_M$) the voltage drop ($U_1$) is measured via the OLED, namely before a significant charge voltage can build up on the replacement capacity ($C_E$), and **in that** the replacement resistance ($R_E$) is then calculated according to the formula

$$R_E = U_1 \: / \: I_M \qquad\qquad (1) \quad .$$

3. Method according to claim 1 or 2, **characterised in that** the OLED for determining the replacement capacity ($C_E$) is subjected over a known charging period ($\Delta t$) to an impressed charging current ($I_M$), **in that** the voltage drop ($U_1$) is measured via the OLED at the start and the voltage drop ($U_2$) at the end of the charging period, and that the replacement capacity ($C_E$) is calculated according to the formula

$$C_E = I_M \cdot \Delta t \: / \: (U_2 - U_1) \qquad\qquad (2) \quad ,$$

wherein, if the charging current flows in the flow direction of the replacement diode ($D_E$), the charging period ($\Delta t$) must be measured so rapidly that the voltage drop ($U_2$) at the end of the charging period is still below the voltage at which the replacement diode ($D_E$) becomes conductive.

4. Method according to claim 1 or 2, **characterised in that** the OLED for determining the replacement capacity ($C_E$) is connected to a known reference capacity ($C_R$) charged previously to a known reference voltage ($U_R$), **in that** then the compensation voltage ($U_A$) on the reference capacity ($C_R$) reduced by the charging compensation or the voltage that is then identical with it is measured on the OLED, and that the replacement capacity ($C_E$) is then calculated according to the formula

$$C_E = C_R \cdot U_R/U_A - 1 \qquad\qquad (3)\ ,$$

wherein, if the reference voltage ($U_R$) is directed in the flow direction of the replacement diode ($D_E$), the reference voltage ($U_R$) must be so measured that the reduced compensation voltage ($U_A$) resulting after the charging compensation is less than the voltage at which the replacement diode ($D_E$) becomes conductive.

5. Method according to any of the preceding claims, **characterised in that** to determine the replacement diode ($D_E$), the current-voltage characteristic of the OLED is measured.

6. Method according to any of the preceding claims, **characterised in that** before the start of measurements the OLED is subjected to start voltage ($U_S$) that is preferably zero.

7. Method for determining the configuration of an OLED combination consisting of a plurality of OLEDs, **characterised in that** the break point of the current-voltage characteristic of the OLED combination is used and evaluated as a distinguishing criterion.

8. Measuring device for determining the electrical properties of an OLED, to perform the method according to any one of claims 1 to 7, **characterised by** means for generating a measuring and/or charging current and means (M) for measuring the voltage drop via the OLED and/or voltage via the reference capacity ($C_R$).

9. Measuring device according to claim 8, further **characterised by** an initial voltage source ($U_s$).

10. Operating device for an OLED, having a measuring device for determining the electrical properties of an OLED, for executing the method according to any one of claims 1 to 7.

11. Operating device according to claim 10, **characterised by** an initial voltage source (Us).

**Revendications**

1. Procédé de détermination des propriétés électriques d'une DELO dont le circuit équivalent consiste en un circuit parallèle d'une diode de remplacement ($D_E$) et d'une capacité de remplacement ($C_E$) et d'une résistance de remplacement ($R_E$) reliée en série à ce circuit parallèle, **caractérisé en ce que** les valeurs pour la résistance de remplacement ($R_E$) et la capacité de remplacement ($C_E$) sont déterminées de façon séparée dans le temps à partir de la détermination des valeurs pour la diode de remplacement ($D_E$) au moyen de la mesure des caractéristiques courant-tension de la DELO, et la DELO pour déterminer la résistance de remplacement ($R_E$) est soumise à un courant de mesure connu ($I_M$), de préférence une impulsion de courant de mesure.

2. Procédé selon la revendication 1, **caractérisé en ce que** immédiatement après le démarrage du courant de mesure ($I_M$) la chute de tension ($U_1$) est mesurée par la DELO, avant qu'une tension de charge significative puisse s'accumuler sur la capacité de remplacement ($C_E$), et **en ce que** la résistance de remplacement ($R_E$) soit alors calculée selon la formule

$$R_E = U_1 \,/\, I_M \qquad\qquad (1)\ .$$

3. Procédé selon les revendications 1 ou 2, **caractérisé en ce que** la DELO pour déterminer la capacité de remplacement ($C_E$) est soumise, au cours d'une période de charge connue ($\Delta t$), à un courant de charge imprimé ($I_M$), **en ce que** la chute de tension ($U_1$) est mesurée par la DELO au démarrage et la chute de tension ($U_2$) à la fin de la période de charge, et **en ce que** la capacité de remplacement ($C_E$) est calculée selon la formule

$$C_E = IM \cdot \Delta t \; / \; (U_2 - U_1) \qquad (2)$$,

dans lequel, si le courant de charge circule dans la direction de flux de la diode de remplacement ($D_E$), la période de charge ($\Delta t$) doit être mesurée très rapidement pour que la chute de tension ($U_2$) à la fin de la période de charge soit encore inférieure à la tension à laquelle la diode de remplacement ($D_E$) devient conductible.

4. Procédé selon les revendications 1 ou 2, **caractérisé en ce que** la DELO pour déterminer la capacité de remplacement ($C_E$) est reliée à une capacité de référence connue ($C_R$) préalablement chargée à une tension de référence connue ($U_R$), **en ce que** donc la tension de compensation ($U_A$) sur la capacité de référence ($C_R$) réduite par la compensation de charge ou la tension qui est alors identique à celle-ci est mesurée sur la DELO, et **en ce que** la capacité de remplacement ($C_E$) est alors calculée selon la formule

$$C_E = C_R \cdot U_R/U_A - 1 \qquad (3)$$,

dans lequel, si la tension de référence ($U_R$) est orientée dans la direction de flux de la diode de remplacement ($D_E$), la tension de référence ($U_R$) doit être mesurée de telle façon que la tension de compensation réduite ($U_A$) résultant après la compensation de charge soit inférieure à la tension à laquelle la diode de remplacement ($D_E$) devient conductible.

5. Procédé selon l'une quelconque des revendications précédentes, **caractérisé en ce que** pour déterminer la diode de remplacement ($D_E$), les caractéristiques courant-tension de la DELO sont mesurées.

6. Procédé selon l'une quelconque des revendications précédentes, **caractérisé en ce que** avant le démarrage des mesures, la DELO est soumise à une tension d'amorçage ($U_S$) de préférence égale à zéro.

7. Procédé de détermination de la configuration d'une combinaison de DELO consistant en une pluralité de DELO, **caractérisé en ce que** le point de rupture des caractéristiques courant-tension de la combinaison de DELO est utilisé et évalué comme un critère de distinction.

8. Dispositif de mesure servant à déterminer les propriétés électriques d'une DELO, pour effectuer le procédé selon l'une quelconque des revendications de 1 à 7, **caractérisé par** des moyens servant à générer un courant de mesure et/ou de charge et des moyens (M) servant à mesurer la chute de tension par le biais de la DELO et/ou la tension par le biais de la capacité de référence ($C_R$).

9. Dispositif de mesure selon la revendication 8, **caractérisé de plus par** une source de tension initiale ($U_s$).

10. Dispositif de fonctionnement pour une DELO, ayant un dispositif de mesure destiné à déterminer les propriétés électriques d'une DELO, pour exécuter le procédé selon l'une quelconque des revendications de 1 à 7.

11. Dispositif de fonctionnement selon la revendication 10, **caractérisé par** une source de tension initiale ($U_s$).

Fig. 1

Fig. 2

12

Fig. 3

Fig. 4

Fig. 5

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1973385 A1